# EUROPÄISCHE PATENTSCHRIFT

(11) **EP 2 635 936 B1**
(45) Veröffentlichungstag und Bekanntmachung des Hinweises auf die Patenterteilung: **21.02.2018**
(21) Anmeldenummer: 11818940.6
(22) Anmeldetag: 07.11.2011
(51) Int. Cl.: G03F 7/16, B05C 13/02, B05C 11/08, B05C 11/10

(54) **ANORDNUNG ZUR HERSTELLUNG VON STRUKTURIERTEN SUBSTRATEN**
ARRANGEMENT FOR THE PRODUCTION OF STRUCTURED SUBSTRATES
ENSEMBLE POUR LA FABRICATION DE SUBSTRATS STRUCTURÉS

(30) Priorität: 07.11.2010 DE 202010015018 U
(43) Veröffentlichungstag der Anmeldung: 11.09.2013
(73) Patentinhaber: Bohnet, Hans, 75328 Schömberg/Langenbrand (DE)
(72) Erfinder: THIEL, Klaus-Peter, 64405 Fischbachtal (DE); BOHNET, Hans, 75328 Schömberg (DE)
(74) Vertreter: Straub, Bernd
(86) Internationale Anmeldenummer: PCT/DE2011/001940
(87) Internationale Veröffentlichungsnummer: WO 2012/059087

(56) Entgegenhaltungen:
- EP-A1- 0 444 714
- EP-A1- 1 577 930
- WO-A1-2004/001812
- WO-A2-2007/076739
- JP-A- 2001 269 609
- JP-A- 2007 311 446
- US-A- 5 871 584
- US-A- 6 159 541
- US-A1- 2004 050 491
- US-A1- 2008 264 457
- US-B1- 6 503 568

## Beschreibung

Die Erfindung bezieht sich auf eine Anordnung zur Herstellung von strukturierten Substraten. Eine solche Anordnung zur Herstellung von strukturierten Substraten wird bei der Herstellung integrierter Schaltungen verwendet.

Der typische Herstellungsprozess für Integrierte Schaltungen verwendet einen oder mehrere fotolithographische Schritte, um Strukturen auf der Oberfläche eines Substrates insbesondere eines Siliziumwafers zu definieren. Diese Strukturen werden in nachfolgenden Schritten verwendet, um eine Vielzahl von Elementen, die zusammen aktive Bauelemente und eine Verbindungsschaltung einer integrierten Schaltung bilden, zu realisieren.

Das Substrat ist normalerweise scheibenförmig ausgebildet. Eine Schachbrettstruktur im Substrat aus quadratischen oder rechteckförmigen Chips ist durch Linien gebildet, entlang derer die Chips getrennt werden können, sobald die Verarbeitungsschritte, die auf dem Substrat durchgeführt werden, beendet sind.

Die herkömmliche Fotolithographie umfasst eine Anzahl von gut bekannten Schritten. Dabei wird das Substrat in eine Beschichtungsvorrichtung mit einem Drehteller gegeben. Dann wird die obere Substratoberfläche, auf der die Schaltungsmerkmale gebildet werden sollen, durch ein flüssiges Lösungsmittel gereinigt. Das Lösungsmittel kann ein geeignetes Bond-Agens einschließen, um die Anhaftung einer Fotopolymerschicht, die nachfolgend auf die Substratoberfläche aufgebracht wird, zu unterstützen.

Als nächstes wird der Drehteller betrieben, um das Substrat zu drehen. Diese Drehbewegung schleudert überschüssiges Lösungsmittel ab, bis die Substratoberfläche trocken zu sein scheint. Dann wird der Drehtisch ausgeschaltet. Nachdem das Substrat zum Stillstand gekommen ist, wird eine vorbestimmte Menge einer Fotopolymerlösung auf der Substratoberfläche aufgebracht. Anschließend wird der Drehtisch in Betrieb genommen, um die flüssige Fotopolymerlösung auf der Substratoberfläche zu verteilen.

Sobald die Fotopolymerlösung getrocknet ist, wird sie auswahlmäßig belichtet, entweder unter Verwendung einer Maske oder unter Verwendung einer Direktschreibtechnik, um jeden Chip in Übereinstimmung mit den erwünschten Konfigurationen einer Schicht des Gesamtlayouts des integrierten Schaltungsentwurfs zu strukturieren. Nachfolgende Schritte, wie zum Beispiel Ätzen, Dotieren, Oxidieren oder verschiedene Ausscheidungsschritte werden unter Verwendung dieser und nachfolgend gebildeter und strukturierter Fotopolymerschichten durchgeführt.

Viele unterschiedliche Faktoren können die Qualität, Gleichmäßigkeit und Zuverlässigkeit der fotolithographischen Techniken, wie sie in bekannten Herstellungsprozessen für Integrierte Schaltungen verwendet werden, nachteilhaft beeinflussen. Diese Faktoren schließen die Materialien, Techniken und Bedingungen des Aufbringens der flüssigen Stoffe insbesondere der Fotopolymerlösungen ein. Idealerweise wird die gebildete Fotopolymerschicht von einer solchen Qualität sein, dass eine genaue Fotoreproduktion aller mikroskopischen Details der Maske zuerst in der Fotopolymerschicht - auch Fotoresistschicht genannt - und dann bei den physikalischen Schaltungselementen, die unter Verwendung dieser Fotopolymerschicht zu bilden sind, ermöglicht ist.

Alle physikalischen, chemischen und Umgebungsfaktoren müssen vorsichtig gesteuert werden, damit keiner der Strukturierungsschritte bezüglich eines Substrats oder der Proportionen der einzelnen Chips fehlschlagen. Manchmal können einzelne Faktoren allein nicht ausreichend sein, um Probleme zu bewirken, aber diese werden in Kombination die Qualität insbesondere der Fotopolymerschicht und anschließend die Qualität der sich ergebenden Schaltungselemente nachteilhaft beeinflussen.

Aus dem europäischen Patent EP 0 403 0 086 B1 ist eine Anordnung zur Herstellung von strukturierten Substraten bekannt.

Die bekannten Beschichtungsanlagen zeigen das Problem, dass die verschiedenen flüssigen Stoffe, insbesondere die Fotopolymerlösungen in so großen Mengen aufgebracht werden, dass erhebliche Überschüsse gegeben sind, die im Hinblick auf die Qualität nicht weiter verwendet werden.

Aus den Patentanmeldungen WO 2004/001812 A1, US 2004/0050491 A1, US 2008/0264457 A1, EP 0 444 714 A1 und JP 2007-311446 A1 sowie dem US-Patent US 5,871,584 B1 sind Anordnungen zum Behandeln von Scheibenförmigen Objekten mit der Möglichkeit abgeschleuderte Behandlungsflüssigkeiten aufzufangen bekannt, die keine Anordnungen zur Beschichtung von Wafern zeigen und die kein Recycling der abgeschleuderten Behandlungsflüssigkeiten offenbaren.

Ähnliche Anordnungen sind aus der Internationalen Patentanmeldung WO 2007/076739 A2 und der japanischen Patentanmeldung JP 2001-269609 A1 bekannt, die ein Beschichten eines Wafers offenbaren, wobei aufgefangene Flüssigkeiten in einer einzigen Auffangschale mit der Möglichkeit, die aufgefangene Flüssigkeit erneut zu verwerten oder zu recyceln, aufgefangen werden.

Aus dem US-Patent US 6,503,568 B1 ist ein Recycling des flüssigen Resist-Stoffes bei einer Anordnung zur Herstellung von strukturierten Substraten durch Hinzufügen von Lösungsmitteln, bis eine bestimmte Viskosität erreicht ist, zu entnehmen. In der Anordnung zur Herstellung von strukturierten Substraten wird der rotierende Teller zur Aufnahme eines Wafers abhängig davon, ob Resist oder ein anderer Stoff aufgebracht wird, vertikal in einer offenen, nicht geschlossenen Anordnung so verschoben, dass der flüssige Resist von den vielen anderen flüssigen Stoffen getrennt durch eine Trennvorrichtung getrennt wird. Allein der getrennte flüssige Resist wird in der beschriebenen Weise recycelt. Die Anordnung zeigt das Problem, dass die verschiedenen flüssigen Stoffe, insbesondere die Fotopolymerlösungen in so großen Mengen aufgebracht werden, dass erhebliche Überschüsse gegeben sind, die im Hinblick auf die Qualität nicht weiter verwendet werden.

Folglich besteht die Aufgabe der vorliegenden Erfindung darin, eine Anordnung zur Herstellung von strukturierten Substraten anzugeben, durch die Mengen der erforderlichen flüssigen Stoffe reduziert werden und damit die Qualität des fotolithografischen Herstellprozesses merklich erhöht wird.

Diese Aufgabe wird durch eine Anordnung zur Herstellung von strukturierten Substraten mit den Merkmalen des Anspruchs 1 gelöst.

Vorteilhafte Weiterbildungen der Anordnung zur Herstellung von strukturierten Substraten sind Gegenstand der Unteransprüche.

Die erfindungsgemäße Anordnung zur Herstellung von strukturierten Substraten zeigt eine Vorrichtung zum Aufbringen von Schichtsystemen auf ein Substrat, die einen abgeschlossenen Raum zeigt, in dem flüssige Stoffe zur Bildung des Schichtsystems aufgebracht werden. Die flüssigen Stoffe insbesondere die Fotopolymerlösungen, die im Rahmen des Fotolithographieprozesses sei es zur Reinigung oder auch zur Bildung der Fotopolymerschicht, auch Fotoresistschicht genannt, sind dabei von besonderer Bedeutung.

In eine rotierende Aufnahme, die häufig als Drehteller bezeichnet wird, wird das kreisförmige Substrat eingebracht und auf dieses wird entweder im statischen oder im dynamischen, rotierenden Zustand der flüssige Stoff insbesondere die Fotopolymerlösung über eine Zuführung aufgebracht. Von dem rotierenden Substrat wird der überschüssige flüssige Stoff, insbesondere die Fotopolymerlösung, abgeschleudert und aus dem abgeschlossenen Raum der Vorrichtung zum Aufbringen von Schichtsystemen entnommen. Hierzu wird erfindungsgemäß eine Auffangvorrichtung um die Aufnahme, diese umschließend, angeordnet, so dass zumindest wesentliche Teile der abgeschleuderten flüssigen Stoffe durch diese Auffangvorrichtung aufgefangen und über mehrere Entnahmen an dieser selektiv entnommen werden. Dabei wird erfindungsgemäß die Auffangvorrichtung und die Entnahme zeitlich oder räumlich so betrieben, dass die unterschiedlichen verwendeten flüssigen Stoffe möglichst sortenrein oder in Gemengen von nur wenigen verschiedenen flüssigen Stoffen entnommen werden können. Dies erfolgt vorzugsweise durch entsprechende zeitliche insbesondere sequentielle Steuerung der Entnahme und/oder durch entsprechende Gestalt, Anordnung bzw. Positionierung der Auffangvorrichtung.

Erfindungsgemäß können die selektiv entnommenen flüssigen Stoffe entweder direkt oder nach einer geringen Aufbereitung wieder in den Prozess zur Herstellung von strukturierten Substraten eingebracht werden, wodurch eine erhebliche Reduktion der Umweltbelastung in Verbindung mit erheblichen Einsparpotentialen gegeben sind.

Erfindungsgemäß wird die Vorrichtung zum Aufbringen von Schichtsystemen mit einem gasdicht ausgebildeten Gehäuse realisiert, wodurch der abgeschlossene Raum zum Aufbringen von flüssigen Stoffen, das heißt das Volumen, in dem das rotierende Substrat angeordnet wird, wie auch die Zuführung sowie die Entnahme mit einem inerten Gas angefüllt ist durch welches der flüssige Stoff, insbesondere die Fotopolymerlösung, von einem Kontakt mit störenden Substanzen der Umgebungsluft insbesondere Sauerstoff oder Luftfeuchtigkeit geschützt wird. Dabei gelingt es den erfindungsgemäß erkannten störenden Einfluss von Sauerstoff, der bei den Fotopolymerlösungen zu einer Oxidation der stark polaren Wasserstoffbrücken führt, sowie Hydroxylgruppen in chinoide Systeme umwandelt, zu vermeiden. Weiterhin gelingt es, störende Verseifungsreaktionen der Fotopolymerlösungen aufgrund der Luftfeuchtigkeit in der Luft zu verhindern, durch die Fotoinitiatoren ihre Reaktionsfähigkeit gegenüber den Photonen in den folgenden Belichtungsschritten im Rahmen des Fotolithographieprozesses verlieren.

Durch diese erfindungsgemäße Ausbildung der Beschichtungsvorrichtung mit einem Beschichtungsraum, der mit einem inerten Gas angefüllt ist, wird die Qualität der verwendeten flüssigen Stoffe insbesondere der Fotopolymerlösungen sowohl vor, während wie auch nach dem Aufbringen erhöht, was zu einer Verbesserung des Gesamtprozesses beziehungsweise der Qualität der hergestellten Chips bei reduziertem Material- und Kostenaufwand führt. Dabei muss der Raum zum Aufbringen von flüssigen Stoffen nicht den ganzen Innenraum des Gehäuses der Vorrichtung zum Aufbringen von Schichtsystemen umfassen.

Dabei wird das Gehäuse der Vorrichtung zum Aufbringen von Schichtsystemen gasdicht, also geschlossen, insbesondere aus V4A-Stahl oder Glas realisiert und dabei so ausgebildet, dass der ganze Innenraum des Gehäuses mit einer Schutzgasatmosphäre also mit inertem Gas versehen ist. Die Zuführung des oder der Substrate erfolgt dabei bevorzugt über eine Schleuse. Fertig beschichtete Substrate werden wiederum gesammelt und über eine insbesondere weitere Schleuse aus der Vorrichtung zum Aufbringen von Schichtsystemen entnommen. Durch die Verwendung der Schleusen gelingt es, die Inertatmosphäre dauerhaft und verlässlich zu erhalten.

Als Ausbildung der Erfindung hat es sich bewährt, die Aufnahme in dem Gehäuse der Vorrichtung zum Aufbringen von Schichtsystemen durch eine ringförmige Auffangvorrichtung zu umschließen, die in dem Raum zum Aufbringen von flüssigen Stoffen angeordnet ist. Dabei zeigt die ringförmige Auffangvorrichtung insbesondere eine Wand, gegen die die von dem rotierenden Substrat abgeschleuderten flüssigen Stoffe prallen und anschließend an der Wand ablaufen. Die Auffangvorrichtung zeigt dabei mehrere voneinander getrennte Auffangbereiche, wobei Trennelemente die Auffangbereiche flüssigkeitsdicht voneinander trennen. Jedem Auffangbereich ist dabei eine Entnahme zugeordnet, mittels welcher die in dem Auffangbereich von der Wand abgelaufenen und aufgefangenen flüssigen Stoffe zielgerichtet und selektiv entnommen werden können. Durch diese erfindungsgemäße Ausbildung können sehr effizient und selektiv die abgeschleuderten flüssigen Stoffe aufgefangen werden, ohne dass diese sich in unerwünschter Weise mischen und sich dabei schädigen.

Durch diese Ausbildung der Auffangvorrichtung und Anordnung dieser in Verbindung mit der inerten Gasfüllung gelingt es sehr effizient, abgeschleuderte flüssige Stoffe, insbesondere Fotopolymere aufzufangen, ohne dass sie durch die schädigende Wirkung der Umgebungsatmosphäre, insbesondere des Luftsauerstoffs oder der Luftfeuchtigkeit, in ihrer Wirksamkeit Schaden nehmen. Dadurch ist es möglich, die in der Auffangvorrichtung selektiv aufgefangenen flüssigen Stoffe, insbesondere die aufgefangenen Fotopolymerlösungen, ohne aufwändige Reinigungs- oder Bearbeitungsprozessschritte der Wiederverwendung in der erfindungsgemäßen Vorrichtung zum Aufbringen von Schichtsystemen zuzuführen.

Dabei sind die unterschiedlichen Auffangbereiche als ringförmige Rinnen ausgebildet, die sich parallel zur Ebene der Aufnahme erstrecken. Insbesondere werden diese ringförmigen Rinnen durch jeweils eine ringförmige Wand realisiert, welche insbesondere an eine einzige gemeinsame insbesondere hohlzylinderförmige oder hohlkegelförmige Wand angeordnet sind. Der Abstand der ringförmigen Wände, die die Trennwände bilden, ist dabei bevorzugt konstant zur jeweils benachbarten Trennwand und somit im Wesentlichen parallel. Hierdurch entsteht eine ringförmige Rinne, welche sich vorzugsweise durch einen keilförmigen Querschnitt auszeichnet. Dies wird dadurch erreicht, dass die Trennwände schräg zur gemeinsamen Wand verlaufend ausgebildet sind. Vorzugsweise wird die im Querschnitt keilförmige ringförmige Rinne ausschließlich durch die parallelen Trennwände und die eine gemeinsame Wand gebildet, wodurch sich eine sehr kompakte, einfach herzustellende und sehr funktionable Ausbildung der unterschiedlichen Auffangbereiche mit Entnahmen ergibt.

Durch diese Ausbildungen ist eine effiziente und einfache Verschiebung der Auffangvorrichtung relativ zur Aufnahme für ein möglichst selektives Auffangen der überflüssigen flüssigen Stoffe gegeben. Diese Auffangvorrichtung erweist sich auch als konstruktiv sehr einfach und wenig anfällig sowie sehr sicher in ihrer Selektionsfunktion. Über die im unteren Bereich der Rinne angeordneten Entnahmen werden insbesondere nach dem Auffangen mehrerer verschiedener flüssiger Stoffe in unterschiedlichen Rinnen diese selektiv entnommen und selektiven Lagergefäßen zugeführt. Dies erfolgt insbesondere mittels einer abgesetzten Entnahmevorrichtung, die als Pumpe oder ventilgesteuerte Druckleitung realisiert ist.

Dabei hat es sich als besonders vorteilhaft erwiesen, die Auffangvorrichtung relativ zur Aufnahme so verschieblich auszubilden, dass abhängig von der Verschiebung unterschiedliche Auffangbereiche zum Auffangen von abgeschleuderten flüssigen Stoffen zur Wirkung kommen. Durch das erfindungsgemäße Verschieben der Auffangvorrichtung können die unterschiedlichen Auffangbereiche in verschiedenen Prozessschritten zur Wirkung kommen und dadurch die für diesen Prozessschritt relevanten flüssigen Substanzen selektiv aufgefangen und über die selektive Entnahme zielgerichtet entnommen werden. Hierbei wird die Position der Auffangvorrichtung relativ zur Aufnahme prozessgesteuert so gewählt, dass die in einem Auffangbereich aufgefangenen flüssigen Stoffe sich wechselseitig nicht oder nur unwesentlich beeinträchtigen und dadurch eine einfache Wiederaufbereitung und Weiterverwendung in der Herstellung von strukturierten Substraten verwendet werden können.

Als für die erfindungsgemäße Vorrichtung besonders geeignetes Glas hat sich Duran-Glas erwiesen, das sich als besonders widerstandsfähig gegen die in der Vorrichtung verwendeten flüssigen und gasförmigen Stoffe und in besonderem Maße gasdicht ist.

Als besonders vorteilhaft erweist es sich, das Inertgas, das bevorzugt als molekularer Stickstoff oder als Edelgas insbesondere als Helium, Neon oder Argon oder einer Kombination daraus gebildet ist, vor der Verwendung in der Vorrichtung zum Aufbringen von Schichtsystemen zu entfeuchten. Dies wird bevorzugt mit Hilfe eines Molekularsiebs realisiert, das mit Hilfe von Zeolithen die vorhandene Restfeuchtigkeit in dem inerten Gas entfernt. Als besonders vorteilhaft hat sich eine Reinheit von 99,99999 % an molekularem Stickstoff bewährt, die durch die Verwendung eines geeigneten Molekularsiebes erreicht wird. Dabei werden sowohl störende größere Moleküle als auch die verbleibende Restfeuchtigkeit in dem molekularen Stickstoff durch die in dem Molekularsieb vorhandenen Zeolithe zurückgehalten.

Durch die besondere Verwendung einerseits des inerten Gases zur Verhinderung der störenden Einflüsse einerseits des Luftsauerstoffes und andererseits der Luftfeuchtigkeit ist in besonderem Maße sichergestellt, dass eine schädigende Wirkung durch die Luft und durch Feuchtigkeit auf die verwendeten flüssigen Stoffe verhindert werden kann.

Durch diese Ausbildung insbesondere aus Glas ist einerseits eine sehr wirkungsvolle Auffangvorrichtung realisiert und zum anderen sichergestellt, dass diese Auffangvorrichtung durch die verwendeten flüssigen Stoffe nicht geschädigt wird. Im Übrigen wird diese Auffangvorrichtung, die bevorzugt aus Glas oder auch aus V4A-Stahl gebildet wird, nicht durch die verwendeten inerten Gase in dem Raum zum Aufbringen von flüssigen Stoffen negativ beeinflusst. Hierdurch gelingt es, Zuführungen ist dabei mit wenigstens einer Entgasungsvorrichtung und zusätzlich insbesondere mit wenigstens einer Entfeuchtungsvorrichtung versehen. Alternativ oder ergänzend hat es sich auch bewährt, die Entnahmevorrichtung mit Lagergefäßen ebenso mit wenigstens einer Entgasungsvorrichtung und insbesondere mit wenigstens einer Entfeuchtungsvorrichtung zu versehen. Hierdurch gelingt es, die Qualität der verwendeten flüssigen Stoffe insbesondere der Fotopolymere über einen längeren Zeitraum auf hohem Niveau zu halten und dadurch die Qualität des Herstellungsprozesses der strukturierten Substrate zu gewährleisten. Dabei hat es sich besonders bewährt, das oder die Lagergefäße bzw. Vorratsbehälter einerseits mit einer Entgasungsvorrichtung und fakultativ oder ergänzend mit einer Entfeuchtungsvorrichtung zu versehen, wodurch es gelingt, in dem Vorratsbehälter eventuell eingebrachte störende Gase oder Feuchtigkeit zu entfernen und dadurch die Qualität der flüssigen Stoffe, welche zur Herstellung der strukturierten Substrate verwendet werden, zielgerichtet zu erhöhen und dabei die Menge der verwendeten flüssigen kostenintensiven Substanzen zu reduzieren. Dabei werden wenigstens ein Lagergefäß bzw. wenigstens ein Vorratsbehälter vorzugsweise aber alle so realisiert, dass über dem Vorrat an flüssigen Stoffen stets eine Atmosphäre aus inerten Gasen insbesondere aus entfeuchteten, inerten Gasen angeordnet ist.

Aus den bekannten Möglichkeiten eine Entgasungsvorrichtung oder eine Entfeuchtungsvorrichtung zu realisieren hat es sich besonders bewährt, diese dadurch zu realisieren, dass im Bodenbereich des Lagergefäßes und/oder des Vorratsbehälters ein flächig ausgebildetes Sieb realisiert ist, das Öffnungen aufweist, durch die zur Entgasung und insbesondere zur Entfeuchtung der flüssigen Stoffe, insbesondere der Fotopolymerlösungen, molekularer Stickstoff und/oder Edelgase hinaus treten und anschließend durch den Vorrat an flüssigen Stoffen, insbesondere Fotopolymerlösungen, aufsteigen und dabei die in den flüssigen Stoffen enthaltenen anderen Gase und insbesondere Restfeuchtigkeit lösen und aus den flüssigen Stoffen entfernen. Anschließend werden die Gase mit der in den Gasen gelösten Restfeuchtigkeit gesammelt und abgepumpt. Dabei wird der molekulare Stickstoff bzw. das Edelgas, das insbesondere aus Helium, Neon und/oder Argon oder einer Kombination daraus besteht, vor der Zuführung über eine Zuführleitung mit Hilfe einer Entfeuchtungsstufe, die insbesondere als Molekularsieb ausgebildet ist, welches insbesondere Zeolithe aufweist, von der in dem zugeführten Gas befindlichen Restfeuchtigkeit befreit. Durch die Verwendung von gereinigtem und entfeuchtetem Gas in dem Vorratsgefäß zur Entgasung und Entfeuchtung der flüssigen Stoffe, insbesondere der Fotopolymere, gelingt es, die für den Herstellungsprozess notwendigen flüssigen Stoffe in hoher Reinheit und Qualität zur Verfügung zu stellen und dadurch die Qualität der hergestellten strukturierten Substrate und damit Chips zu hochzuhalten.

Nach einer bevorzugten Ausbildung der erfindungsgemäßen Beschichtungsanlage ist das Lagergefäß ebenso wie der oder die Vorratsbehälter mit einer Entgasungsvorrichtung und insbesondere mit einer Entfeuchtungsvorrichtung versehen, wodurch es möglich ist, die durch den Herstellungsprozess mit unerwünschtem Gas oder Feuchtigkeit verunreinigten flüssigen Stoffe, insbesondere die Fotopolymere, von den gasförmigen oder flüssigen Verunreinigungen zu befreien, was analog zu der Entgasung beziehungsweise Entfeuchtung in dem Vorratsbehälter erfolgt.

Danach kann die Qualität der flüssigen Stoffe mithilfe von Viskositätsmessgeräten bestimmt werden und gegebenenfalls durch Zusatz von Lösungsmitteln und/oder Harzen die gewünschte Viskosität eingestellt werden, bevor sie dem weiteren Herstellungsprozess zugeführt werden. Dabei hat es sich besonders bewährt, die aus der Auffangvorrichtung, aus der Entnahmevorrichtung oder aus dem oder den Lagergefäßen entnommenen flüssigen Stoffe fakultativ einer Feinstfiltration durch Partikelfilter mit einer Porengröße von etwa 0,01 µm oder darunter zu filtrieren. Als besonders geeignete Filter haben sich hier so genannte Nanoshield-Filter, da sind Nanotube-Filter, bewährt. Hierdurch gelingt es, extrem kleine störende Partikel und Gelpartikel aus den flüssigen Stoffen, insbesondere aus den Fotopolymerlösungen, zu entfernen und dadurch die Qualität der flüssigen Stoffe, insbesondere der Fotopolymerlösungen, auf einem sehr hohen Qualitätsstandard zu halten. Durch dieses besondere erfindungsgemäße Verfahren gelingt es, eine Qualität im Subppb-Bereich zu realisieren. Ergänzend oder alternativ hat sich der Einsatz von Molekularsieben oder Filtern mit Manganoxid und/oder Raseneisenerz bewährt.

Nach einer bevorzugten Ausbildung der Erfindung werden die aufgefangenen flüssigen Stoffen aus den Lagergefäßen entnommen und einer Vakuumdestillationsvorrichtung zugeführt. Diese Vakuumdestillationsvorrichtung trennt die selektierten flüssigen Stoffe in die Bestandteile insbesondere Wasser, Lösungsmittel und weitere flüssige Bestandteile wie Beschichtungsbestandteilen, die anschließend jeweils in zugeordnete gasdichte Behälter überführt werden. Dabei erfolgt die Vakuumdestillation vorzugsweise so, dass die Destillationstemperatur merklich unter 70°C gehalten wird. Dies wird insbesondere dadurch erreicht, dass unter einem Unterdruck im Bereich von wenigen mbar insbesondere im Bereich von 10 bis 20 mbar gearbeitet wird. Bei diesen gewählten Destillationsbedingungen gelingt es, die dort verwendeten Lösungsmittel sicher von den Beschichtungsbestandteilen, die aus den verwendeten flüssigen Stoffen, insbesondere den Fotopolymeren, hervorgehen, zu trennen, ohne dass diese flüssigen Stoffe, insbesondere die Fotopolymere, durch die Destillation zersetzt werden oder anderweitig Schaden nehmen. Auch gelingt es aus dem potentiell vorliegenden azeotropen Gemisch mit Wasser, dieses abzutrennen und dadurch die Qualität der Lösungsmittel und der weiteren flüssigen oder festen Beschichtungsbestandteile zu bewahren oder durch die Trennung zu erhöhen. Dies ermöglicht die erfindungsgemäße vorteilhafte Weiternutzung der Bestandteile in dem Prozess der Herstellung von strukturierten Substraten.

Durch diese erfindungsgemäße Ausbildung der Beschichtungsanlage gelingt es, die flüssigen Stoffe, die durch die Verwendung von Lösungsmitteln bei der Aufbringung eines Schichtsystems auf das Substrat gelöst wurden, wieder zu recyceln und aufgrund der erfindungsgemäßen Realisierung der Anlage in einer Qualität zu recyceln, die es ermöglicht, dass die gelösten, vakuumdestillierten, flüssigen Stoffe, insbesondere die Fotopolymere, wieder dem Herstellungsprozess zugeführt werden können. Dies erfolgt bevorzugt durch Zuführung in einen der erfindungsgemäßen Vorratsbehälter.

Vorzugsweise werden die recycelten flüssigen Stoffe, insbesondere die Fotopolymere, durch Zuführung unter anderem von Harzen oder Lösungsmitteln in ihrer Viskosität so eingestellt, dass sie im Herstellungsprozess wirksam und effektiv verwendet werden können. Darüber hinaus hat es sich bewährt, die flüssigen Stoffe vor der Zuführung in den Vorratsbehälter mit einem Molekularsieb von Verunreinigungen, insbesondere von gelöster Feuchtigkeit, zu reinigen.

Da die unerwünschten Substanzen regelmäßig einen hohen Massenwert insbesondere im Bereich von 1000 haben, hat sich der erfindungsgemäße Einsatz von Molekularsieben zur Reinigung der verwendeten flüssigen Stoffe insbesondere der verwendeten Lösungsmittel im besonderen Maße bewährt. Auf aufwändige Destillationen oder andere Recyclingsmaßnahmen kann dabei in weitem Maße verzichtet werden.

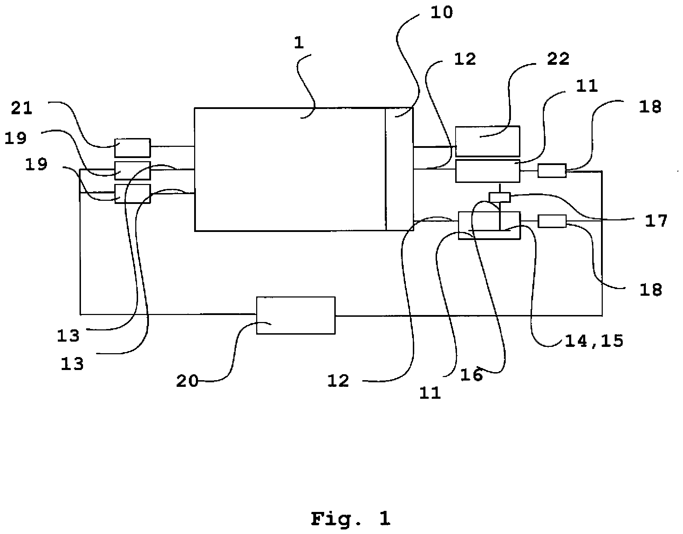

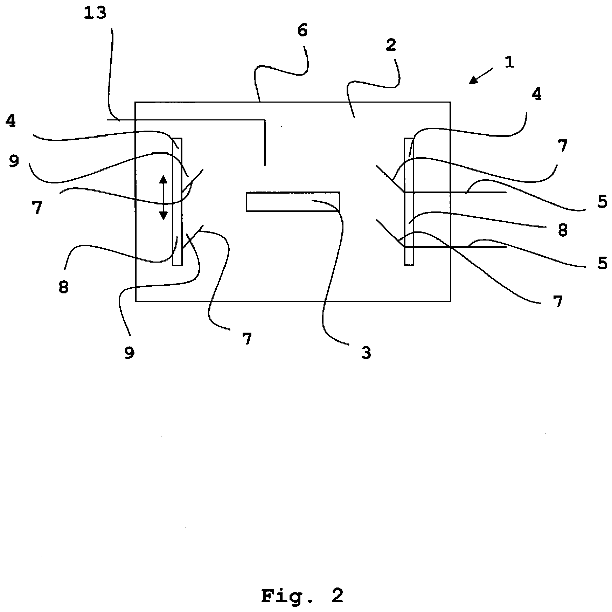

Nachfolgend ist in Figur 1 bzw. in Figur 2 eine beispielhafte Ausführung der Erfindung dargestellt. Die Erfindung ist nicht auf die beispielhaft dargestellten Realisierungen der erfindungsgemäßen Anordnung zur Herstellung von strukturierten Substraten begrenzt, vielmehr umfasst die Erfindung auch davon abweichende Lösungen, die sich einem Fachmann aus der Gesamtheit der vorliegenden Unterlagen mit den beispielhaften Lösungen erschließen.

In der Figur 1 ist eine schematische Darstellung einer ausgewählten erfindungsgemäßen Anordnung zur Herstellung von strukturierten Substraten dargestellt.

Neben einer Vielzahl anderer, nicht dargestellter Komponenten der Anordnung zur Herstellung von strukturierten Substraten stellt die Anordnung zur Herstellung von strukturierten Substraten Vorrichtung zum Aufbringen von Schichtsystemen 1 die zentrale Komponente der Anordnung zur Herstellung von strukturierten Substraten dar. In ihr ist eine Aufnahme 3 in dem abgeschlossenen Raum 2 zum Aufbringen von flüssigen Stoffen angeordnet, der durch das Gehäuse 6, welches aus V4A-Stahl und damit gasdicht ausgebildet ist, umschlossen ist. In dem Raum 2 ist erfindungsgemäß eine Atmosphäre aus inertem Gas vorhanden. Wird die Aufnahme 3 mit einem zu strukturierenden Substrat bestückt, auf das über die Zuführung 13 flüssige Stoffe zum Beispiel eine Fotopolymerlösung zugeführt wird, so wird durch die rotierende Aufnahme 3 die Fotopolymerlösung über das flächige scheibenförmige Substrat aufgrund der Rotation desselben verteilt. Die überschüssigen flüssigen Stoffe wie die Fotopolymerlösung werden dabei von dem rotierenden Substrat abgeschleudert.

Durch die erfindungsgemäße Ausbildung der Vorrichtung zum Aufbringen von Schichtsystemen 1 mit einer Atmosphäre aus Inertgas gelingt es, eine Beschädigung oder Zerstörung der zugeführten Fotopolymerlösung zu verhindern und dadurch die Qualität des Herstellungsprozesses, der wesentlich von der Qualität der verwendeten Lösungen insbesondere der Fotopolymerlösungen abhängt, hochzuhalten. Dabei ist die inerte Atmosphäre insbesondere durch entfeuchteten molekularen Stickstoff realisiert, der einen Kontakt von Sauerstoff, insbesondere aus der Umgebungsluft, oder von Feuchtigkeit aus der Umgebungsluft verhindert.

Der Sauerstoff führt zu einer Schädigung der Fotopolymerlösung aufgrund der Oxidation der stark polaren Wasserstoffbrücken und der Umwandlung der Hydroxylgruppen in chinoide Systeme. Auch eine unerwünschte Verseifung der Fotopolymerlösungen aufgrund der Feuchtigkeit insbesondere aus der Umgebungsluft kann erfolgreich durch die gewählte Inertatmosphäre verhindert werden.

Erfindungsgemäß werden die von dem Substrat abgeschleuderten flüssigen Stoffe wie die Fotopolymerlösung durch eine Auffangvorrichtung 4 aufgefangen. Diese Auffangvorrichtung 4 ist aus Glas realisiert. Sie umschließt die Aufnahme 3 ringförmig und ist in dem gasdichten Gehäuse 6 angeordnet. Die Auffangvorrichtung 4 zeigt eine hohlzylindrische Gestalt, wobei die Wand 8 des Hohlzylinders auf der der Aufnahme zugewandte Innenseite mehrere Trennelemente 7 aufweist, die die Innenwand ringförmig begrenzen und dabei mehrere ringförmige Rinnen 9 bilden. In diesen Rinnen 9 werden die abgeschleuderten flüssigen Stoffe aufgefangen, sie bilden die Auffangbereiche 9. Dabei sind die wandförmig ausgebildeten Trennelemente 7 im Wesentlichen parallel zueinander und mit gleichem Abstand zueinander an der gemeinsamen Wand 8 angeordnet. Am unteren Ende der ringförmigen Rinnen 9 ist jeweils eine Entnahme 5 angeordnet, mittels der die in der Rinne 9 aufgefangenen flüssigen Stoffe wie Fotopolymerlösungen selektiv entnommen werden können. Durch ein vertikales Verschieben der Auffangvorrichtung 4 werden unterschiedliche Auffangbereiche 9 in den Abschleuderbereich der Aufnahme 3 verfahren, wodurch eine Trennung der verschiedenen in verschiedenen Prozessschritten zur Herstellung eines strukturierten Substrates verwendeten flüssigen Stoffe auf einfache und effiziente Weise ermöglicht ist. Eine wechselseitige Kontaminierung der flüssigen Stoffe ist dadurch deutlich reduziert.

Nachdem ein flüssiger Stoff über die Zuführung 13 mittels einer Düse auf das rotierende Substrat in der Aufnahme 3 aufgebracht ist, wird durch die Rotation der überschüssige Teil des flüssigen Stoffes radial vom rotierenden Substrat abgeschleudert und prallt, nachdem er das Substrat verlassen hat, auf die ihn ringförmig umgebende Wand 8 der Auffangvorrichtung 4. Von der gemeinsamen Wand 8 tropft der flüssige Stoff dann nach unten in den als ringförmige Rinne 9 ausgebildeten Auffangbereich 9. Durch die parallele Ausbildung der Trennelemente 7 zur Bildung der im Querschnitt keilförmigen Rinnen 9 wird zudem sichergestellt, dass abgeschleuderte flüssige Stoffe, die nicht die Wand 8 sondern das darüber liegende Trennelement 7 treffen, ebenso in die darunter liegende ringförmige und im Querschnitt keilförmige Rinne 9 gelangen, wodurch das selektive Auffangen der flüssigen Stoffe in den darunter liegenden Auffangbereichen 9 im besonderen Maß sichergestellt ist. Dabei werden die Rinnen ausschließlich durch die gemeinsame Wand 8 und die parallelen Trennelemente 7 gebildet. Es ist hiermit eine sehr einfache und gut handhabbare Auffangvorrichtung 4 geschaffen, die relativ zu der während der Rotationsphase in der vertikalen Lage unveränderlichen Aufnahme 3 verschieblich ausgebildet ist.

Durch die Möglichkeit der Verschiebung der Auffangvorrichtung 4 ist es erfindungsgemäß möglich, die Entnahme nicht kontinuierlich während des Herstellungsprozesses vornehmen zu müssen sondern immer wieder zum geeigneten Zeitpunkt vornehmen zu können. Hierdurch ist es erfindungsgemäß möglich, im Herstellungsprozess mehrfach verwendete flüssige Stoffe selektiv aufzusammeln und dann zu einem späteren Zeitpunkt insbesondere auf ein einziges Mal über die zugeordnete selektive Entnahme 5 zu entnehmen. Dadurch gelingt es, den Prozess der Herstellung noch weiter zu vereinfachen und die Qualität der abgeschleuderten flüssigen Stoffe aufgrund der deutlich reduzierten wechselseitigen Kontaminierung in Verbindung mit den weiteren Schutzmaßnahmen wie inertes Gas, Entgasung oder Entfeuchtung ausgesprochen hoch zu halten.

Gerade mit Hilfe einer Anordnung aus Vorratsbehälter 19 mit Entgasungs- und Entfeuchtungsvorrichtung sowie der Vorrichtung zum Aufbringen von Schichtsystemen 1 mit inerter Atmosphäre im Raum 2 und der Auffangvorrichtung 4 mit einer Entnahmevorrichtung 10 sowie den gasdicht ausgebildeten Lagergefäßen 11 mit Entgasungsvorrichtung 14 und Entfeuchtungsvorrichtung 15 gelingt es, in den Lagergefäßen 11 flüssige Stoffe unter anderem Fotopolymerlösungen zu sammeln, die im Wesentlichen in der Qualität der ursprünglich verwendeten flüssigen Stoffe zum Beispiel der Fotopolymerlösungen in den Vorratsbehältern 19 entspricht. Um die Qualität noch zu erhöhen, wird zusätzlich vor einer Förderung der Fotopolymerlösung aus dem Lagergefäß 11 in den Vorratsbehälter 19 diese Lösung durch einen Partikelfilter 18, einen Nanoshield-Filter, geführt. Durch diese Realisierung der Vorratsbehälter 19 und der Lagergefäße 11 ist die Qualität der flüssigen Stoffe für den Herstellungsprozess von strukturierten Substraten in der erfindungsgemäßen Anordnung zur Herstellung von strukturierten Substraten auf besonders hohem Niveau gewährleistet.

Auch ist es nun möglich, einen Herstellungsprozess mit geschlossenem Kreislauf für einzelne flüssige Stoffe zu realisieren, der, beginnend mit dem Vorratsgefäß 19, der Vorrichtung zum Aufbringen von Schichtsystemen 1 und den Lagergefäßen 11 mit den zugehörigen Transport- und Zuleitungen, ein geschlossenes, gasdichtes und insbesondere inertgasgefülltes System bildet, das insgesamt eine sehr dauerhafte hohe Qualität zum Beispiel der Fotopolymerlösung gewährleistet. Hierdurch ist ein sehr effizientes und qualitativ hoch stehendes Herstellungsverfahren von strukturierten Substraten durch die erfindungsgemäße Anordnung gewährleistet.

Nach der Beschichtung mit der Fotopolymerlösung wird eine so genannte Randentlackung bzw. Rückseitenspülung durchgeführt. Hierbei werden Bereiche des beschichteten Substrats von der Fotopolymerschicht befreit. Hierzu werden als flüssige Stoffe Lösungsmittel verwendet, die geeignet sind, als Lösungsmittel für die mit der Fotopolymerlösung gebildete Beschichtung verwendet zu werden. Als besonders vorteilhaft hat sich hierbei PGMEA (Propylen Glykol Monomethyl Ether Acetate), EL (Ethyl Lactate), MMP (Methyl 3-Methoxypropionate) oder EEP (Ethyl 3-Ethoxypropionate) bewährt.

Das Lösungsmittel wird aus einem Vorratsbehälter 19, der ebenso wie die anderen Vorratsbehälter 19 oder die Lagergefäße 11 aus gasdichtem V4A-Stahl gebildet ist und mit einer Schutzgasatmosphäre aus inertem, molekularem, getrocknetem Stickstoff versehen ist, gefördert. Das geförderte Lösungsmittel wird über eine Förderleitung in die Zuführung 13 in die Vorrichtung zur Herstellung eines Schichtsystems gefördert.

Dort wird das Lösungsmittel in den Randbereich des Substrats zielgerichtet aufgebracht. Im Rahmen dieses Prozessschrittes wird die Beschichtung des mit der getrockneten Fotopolymerlösung beschichteten Substrats partiell entfernt und die Mischung aus Lösungsmittel und gelöster Beschichtung in einen selektiven Auffangbereich 9 abgeschleudert und dann über die selektive Entnahme 5 aus der Vorrichtung 1 entnommen. Durch die in der Vorrichtung 1 vorhandene inerte Atmosphäre ist sichergestellt, dass das Lösungsmittel nicht durch störende Partikel der Umgebungsluft, insbesondere durch Sauerstoff oder Feuchtigkeit verunreinigt wird, was in folgenden Recyclingprozessen zu einer Schädigung der Lösungsmittel bzw. der Fotopolymerlösung führt.

Die über die Entnahme 5 entnommenen flüssigen Stoffe werden, nachdem sie in die Lagergefäße 11 eingebracht worden sind, zumindest teilweise einer Entgasung mittels einer Entgasungsvorrichtung 11 unterzogen. Hierbei wird über ein am Boden des Lagergefäßes 11 befindliches Sieb entfeuchtete inerte Gase wie z.B. getrockneter Stickstoff in die flüssigen Stoffe eingebracht um diese einerseits zu entfeuchten und andererseits zu entgasen. Das entfeuchtete inerte Gas wird dem Sieb dabei über eine Zuführleitung 16 zugeführt, in der ein Molekularsieb 17 für die Entfeuchtung des inerten Gases angeordnet ist. Aus dem Lagergefäß 11 wird der flüssige Stoff entnommen und einem Partikelfilter 18 zugeführt, der als Nanoshield-Filter mit einem Porendurchmesser der Nanotubes im Bereich von 0,1 µm oder insbesondere im Bereich von 0,01 µm realisiert ist. Hierdurch ist gewährleistet, dass sowohl das Lösungsmittel wie auch die gelösten Fotopolymere sicher durchtreten können, wohingegen größere Komplexe insbesondere gelartige Partikel zurück gehalten werden. Neben dem Lagergefäß 11 und der Zuführleitung 16 sind auch die anderen Leitungen insbesondere die Transportleitung 12 aus V4A-Stahl gasdicht realisiert.

Dabei wird das zu strukturierende Substrat über einen Vorrat 21 in Verbindung mit einer Schleuse in die Vorrichtung zum Aufbringen von Schichtsystemen 1 eingebracht um diese dort in die Aufnahme 3 einzubringen. Nach abgeschlossener Strukturierung wird das strukturierte Substrat wiederum aus der Vorrichtung zum Aufbringen von Schichtsystemen 1 wiederum über eine weitere Schleuse entnommen und in einen Lagerraum 22 verbracht. Durch diese Ausbildung der Anordnung gelingt es, die inerte Atmosphäre aufrecht zu erhalten und dadurch die Qualität des Prozesses und dadurch die Qualität der flüssigen Stoffe und auch die Qualität des Herstellungsprozesses gerade im Hinblick auf die damit verbundenen Kosten zu hoch zu halten.

Um die Qualität und insbesondere Reinheit der abgeschleuderten flüssigen Stoffe insbesondere der Lösungsmittel noch weiter zu erhöhen, werden diese zumindest teilweise nach den vorgenannten Prozessschritten einer Vakuumdestillationsvorrichtung 20 zugeführt. Diese Vakuumdestillationsvorrichtung 20 arbeitet bei einer Temperatur von etwa 65 °C und bei einem Druck von etwa 10 bis 20 mbar. Mithilfe dieser Vakuumdestillationsvorrichtung 20 gelingt es unter anderem, Polymerlösungen von 100 bis 500 mpas aus den selektiv aufgefangenen flüssigen Stoffen zu trennen und die davon wiederum getrennten Lösungsmittel sehr rein zu gewinnen. Die Vakuumdestillationsvorrichtung 20 zeigt dabei eine Destillationsleistung von 500 l/h.

Die Lösungsmittel werden anschließend in Vorratsbehälter 19 überführt, wohingegen die Fotopolymerlösungen davon getrennt in einen anderen Vorratsbehälter 19 überführt werden, von dem aus nach einer Einstellung der gewünschten Viskosität, die von besonderer Bedeutung für den Herstellungsprozess eines Schichtsystems ist, diese im Herstellungsprozess wieder verwendet werden können. Die Einstellung der Viskosität erfolgt durch Zugabe von Lösungsmittel zur Verringerung der Viskosität bzw. von Harzen zur Erhöhung der Viskosität.

Auch hat es sich bewährt, bis zu 1 % Imidazol zuzugeben, das die Temperaturstabilität und die Plasmaätzstabilität des beschichteten Substrats verbessert. Auch hat es sich bewährt, temperaturbeständige Nanopartikel beispielsweise als Fullerene oder Rutheniumoxid mit einem Durchmesser von ca. 25 nm zuzugeben, die wiederum die Temperaturbeständigkeit und die Widerstandskraft beim Plasmaätzen oder bei der Ionenimplantation des beschichteten Substrats verbessern.

Durch diese erfindungsgemäße Art der Realisierung der Anordnung zur Herstellung von strukturierten Substraten gelingt es, eine Einsparquote für Fotopolymere größer 90 % bzw. eine Einsparquote von größer 99 % für die verwendeten Lösungsmittel zu erreichen. Diese Lösungsmittel wie auch die Fotopolymere stellen kostenintensive Faktoren für die Herstellung von strukturierten Substraten dar, weshalb es durch die erfindungsgemäße Anordnung gelingt, die Kosten für die Herstellung von strukturierten Substraten gerade durch die Verringerung der verwendeten Materialien erheblich zu reduzieren.

## Patentansprüche

1. Anordnung zur Herstellung von strukturierten Substraten mit einem Recycling von flüssigen Stoffen mit einer Vorrichtung zum Aufbringen von Schichtsystemen (1) auf ein Substrat,
mit einem abgeschlossenen Raum (2) zum Aufbringen von flüssigen Stoffen zur Bildung des Schichtsystems, wobei dieser eine rotierende Aufnahme (3) für Substrate und eine die rotierende Aufnahme (3) umschließende in dem Raum (2) zum Aufbringen von flüssigen Stoffen angeordnete Auffangvorrichtung (4) zur Aufnahme von vom Substrat abgeschleuderten flüssigen Stoffe aufweist,
wobei die Auffangvorrichtung mehrere Entnahmen (5) aufweist, mittels derer flüssige aufgefangene Stoffe einzeln oder in Gemengen selektiv entnehmbar sind und entweder direkt oder nach einer geringen Aufbereitung wieder in den Prozess zur Herstellung von strukturierten Substraten eingebracht werden können,
wobei die Auffangvorrichtung (4) in dem Raum (2) die Aufnahme (3) ringförmig umschließt und mehrere durch Trennelemente (7) voneinander getrennte Auffangbereiche (9) zur Aufnahme von abgeschleuderten flüssigen Stoffen aufweist und
wobei die Auffangvorrichtung (4) auf der der Aufnahme (3) zugeordneten Seite mehrere wandförmige Trennelemente (7) aufweist, die mehrere ringförmige Rinnen (9) als Auffangbereiche (9) bilden, die mit einer oder mehreren Entnahmen (5) versehen sind,
wobei die Auffangvorrichtung (4) auf der der Aufnahme (3) zugeordneten Seite mehrere wandförmige Trennelemente (7) aufweist, die mehrere ringförmige im Querschnitt keilförmige Rinnen (9) als Auffangbereiche (9) bilden, die mit einer oder mehreren Entnahmen (5) versehen sind, wobei die Auffangvorrichtung mit den mehreren ringförmig und im Querschnitt keilförmige ausgebildeten Rinnen (9, die die Auffangbereiche (9) bilden, verschieblich ausgebildet sind,
wobei mehrere ringförmige Rinnen (9) ausschließlich durch wandförmige Trennelemente (7) und eine gemeinsame Wand (8) der Auffangvorrichtung (4) gebildet sind,
wobei der Raum (2) zum Aufbringen von flüssigen Stoffen durch ein Gehäuse (6) gasdicht ausgebildet ist und wobei der Raum (2) zum Aufbringen von flüssigen Stoffen mit inertem Gas gefüllt ist.

2. Anordnung zur Herstellung von strukturierten Substraten nach Anspruch 1,
**dadurch gekennzeichnet, dass** die Auffangvorrichtung (4) relativ zur Aufnahme (3) so verschieblich ausgebildet ist, dass abhängig von der Verschiebung unterschiedliche Auffangbereiche (9) zum Auffangen von abgeschleuderten flüssigen Stoffen zur Wirkung kommen.

3. Anordnung zur Herstellung von strukturierten Substraten nach Anspruch 1 oder 2,
**dadurch gekennzeichnet, dass** die gemeinsame Wand (8) die Gestalt eines Hohlzylinders oder eines Hohlkegels aufweist.

4. Anordnung zur Herstellung von strukturierten Substraten nach einem der Ansprüche 1 bis 3,
**dadurch gekennzeichnet, dass** die wandförmigen Trennelemente (7) im Wesentlichen parallel zueinander sind.

5. Anordnung zur Herstellung von strukturierten Substraten nach einem der vorstehenden Ansprüche,
**dadurch gekennzeichnet, dass** der Raum (2) zum Aufbringen von flüssigen Stoffen durch ein Gehäuse (6) gasdicht aus V4A-Stahl oder Glas umschlossen ist.

6. Anordnung zur Herstellung von strukturierten Substraten nach einem der vorstehenden Ansprüche,
**dadurch gekennzeichnet, dass** der Raum (2) zum Aufbringen von flüssigen Stoffen mit entfeuchtetem inertem Gas gefüllt ist.

7. Anordnung zur Herstellung von strukturierten Substraten nach einem der vorstehenden Ansprüche 1 bis 6,
**dadurch gekennzeichnet, dass** eine von dem Raum (2) zum Aufbringen von flüssigen Stoffen abgesetzte Entnahmevorrichtung (10) vorgesehen ist, die die in der Auffangvorrichtung (4) gesammelten flüssigen Stoffe über die Entnahmen (5) selektiv in getrennte Lagergefäße (11) fördert,
wobei die Lagergefäße (11) zur Lagerung insbesondere von entgasten und/oder entfeuchteten flüssigen Stoffen, insbesondere von Fotopolymerlösungen, geeignet sind.

8. Anordnung zur Herstellung von strukturierten Substraten nach Anspruch 7,
**dadurch gekennzeichnet, dass** das Lagergefäß (11) aus V4A-Stahl oder Glas gefertigt ist und über eine gasdichte Transportleitung (12) mit der Auffangvorrichtung (4) und der Entnahmevorrichtung (10) verbunden ist.

9. Anordnung zur Herstellung von strukturierten Substraten nach einem der Ansprüche 1 bis 8,
**dadurch gekennzeichnet, dass** wenigstens eine Zuführung (13) für die flüssigen Stoffe zum Raum (2) zum Aufbringen von flüssigen Stoffen vorgesehen ist und die wenigstens eine Zuführung (13) und/oder die Entnahmevorrichtung (10) mit Lagergefäßen (11) mit wenigstens einer Entgasungsvorrichtung (14) und insbesondere mit wenigstens einer Entfeuchtungsvorrichtung (15) versehen ist.

10. Anordnung zur Herstellung von strukturierten Substraten nach Anspruch 9,
**dadurch gekennzeichnet, dass** die Entgasungsvorrichtung (14) eine Zuführleitung (16) für inertes Gas insbesondere für molekularen Stickstoff und/oder Edelgas insbesondere Helium, Neon oder Argon
und ein im Bodenbereich des Lagergefäßes (11) angeordnetes Sieb aufweist, durch dessen Öffnungen zur Entgasung und insbesondere zur Entfeuchtung der flüssigen Stoffe, insbesondere von Fotopolymerlösungen, inertes Gas insbesondere als getrocknetes Gas strömt.

11. Anordnung zur Herstellung von strukturierten Substraten nach Anspruch 10,
**dadurch gekennzeichnet, dass** die Zuführleitung (12) mit einem Molekularsieb (17) oder Mangandioxid- oder Raseneisenerz-Filtern zur Entfeuchtung des durchströmenden inerten Gases versehen ist.

12. Anordnung zur Herstellung von strukturierten Substraten nach einem der vorstehenden Ansprüche,
**dadurch gekennzeichnet, dass** nach der Auffangvorrichtung (4) ein Filter zur Partikelfiltration (18) vorgesehen ist.

13. Anordnung zur Herstellung von strukturierten Substraten nach einem der vorstehenden Ansprüche 7 bis 12, **dadurch gekennzeichnet, dass** eine Vakuumdestillationsvorrichtung (20) vorgesehen ist, die die flüssigen Stoffe in den verschieden Lagergefäßen (11) durch Destillation in seine Bestandteile insbesondere in Wasser, Lösungsmittel und flüssige Stoffe, insbesondere in die Fotopolymerlösungen, trennt und abgetrennten Bestandteile in gasdichte Vorratsbehälter (19) überführt, wobei diese insbesondere mit einer Atmosphäre aus inertem Gas versehen sind.

## Claims

1. Arrangement for producing structured substrates with recycling of liquid materials, comprising a device for applying layer systems (1) to a substrate,
comprising a closed chamber (2) for applying liquid materials for forming layer systems, the said chamber having a rotating holder (3) for substrates and a collecting device (4) enclosing the rotating holder (3) and arranged in the chamber (2) for applying liquid materials, for holding liquid materials thrown off from the substrate,
wherein the collecting device has a plurality of removal means (5), by means of which liquid collected materials can be removed individually or selectively in batches and, either directly or following little conditioning, can be introduced again into the process for producing structured substrates,
wherein the collecting device (4) in the chamber (2) encloses the holder (3) annularly and has multiple collecting regions (9), separated from one another by separating elements (7), for holding liquid materials that are thrown off, and wherein the collecting device (4) has, on the side assigned to the holder (3), multiple wall-like separating elements (7), which form multiple annular channels (9) as collecting regions (9), which are provided with one or more removal means (5),
wherein the collecting device (4) has, on the side assigned to the holder (3), multiple wall-like separating elements (7), which form multiple annular channels (9) of wedge-like cross section as collecting regions (9), which are provided with one or more removal means (5), wherein the collecting device having the multiple annular channels (9) of wedge-like cross section, which form the collecting regions (9), are designed to be displaceable,
wherein multiple annular channels (9) are formed exclusively by wall-like separating elements (7) and a common wall (8) of the collecting device (4),
wherein the chamber (2) for applying liquid materials is formed in a gas-tight manner by a housing (6), and
wherein the chamber (2) for applying liquid materials is filled with inert gas.

2. Arrangement for producing structured substrates according to Claim 1,
**characterized in that** the collecting device (4) is designed to be displaceable relative to the holder (3) such that, depending on the displacement, different collecting regions (9) for collecting liquid materials that are thrown off come into effect.

3. Arrangement for producing structured substrates according to Claim 1 or 2,
**characterized in that** the common wall (8) has the shape of a hollow cylinder or a hollow cone.

4. Arrangement for producing structured substrates according to one of Claims 1 to 3,
**characterized in that** the wall-like separating elements (7) are substantially parallel to one another.

5. Arrangement for producing structured substrates according to one of the preceding claims, **characterized in that** the chamber (2) for applying liquid materials is enclosed in a gas-tight manner by a housing (6) of V4A steel or glass.

6. Arrangement for producing structured substrates according to one of the preceding claims, **characterized in that** the chamber (2) for applying liquid materials is filled with dried inert gas.

7. Arrangement for producing structured substrates according to one of the preceding Claims 1 to 6, **characterized in that** a removal device (10) detached from the chamber (2) for applying liquid materials is provided, which conveys the liquid materials collected in the collecting device (4) selectively into separate storage vessels (11) via the removal means (5),
wherein the storage vessels (11) are suitable for storing in particular de-gassed and/or dried liquid materials, in particular photopolymer solutions.

8. Arrangement for producing structured substrates according to Claim 7,
**characterized in that** the storage vessel (11) is made of V4A steel or glass and is connected via a gas-tight transport line (12) to the collecting device (4) and the removal device (10).

9. Arrangement for producing structured substrates according to one of Claims 1 to 8,
**characterized in that** at least one feed (13) for the liquid materials to the chamber (2) for applying liquid materials is provided, and the at least one feed (13) and/or the removal device (10) is provided with storage vessels (11) having at least one de-gassing device (14) and in particular with at least one drying device (15).

10. Arrangement for producing structured substrates according to Claim 9,
**characterized in that** the de-gassing device (14) has a feed line (16) for inert gas, in particular for molecular nitrogen and/or noble gas, in particular helium, neon or argon, and a screen arranged in the bottom region of the storage vessel (11), through the openings of which inert gas, in particular as dried gas, flows for de-gassing and in particular for drying the liquid materials, in particular photopolymer solutions.

11. Arrangement for producing structured substrates according to Claim 10,
**characterized in that** the feed line (12) is provided with a molecular sieve (17) or manganese dioxide or bog iron ore filters for drying the inert gas flowing through.

12. Arrangement for producing structured substrates according to one of the preceding claims, **characterized in that** a filter for particle filtration (18) is provided after the collecting device (4).

13. Arrangement for producing structured substrates according to one of the preceding Claims 7 to 12, **characterized in that** a vacuum distillation device (20) is provided, which separates the liquid materials into the various storage vessels (11) by means of distillation into their constituents, in particular into water, solvent and liquid materials, in particular into the photopolymer solutions, and transfers separated constituents into gas-tight storage containers (19), wherein these are in particular provided with an atmosphere of inert gas.

## Revendications

1. Ensemble pour la fabrication de substrats structurés avec un recyclage de substances liquides avec un dispositif pour déposer des systèmes de couches (1) sur un substrat,
avec une chambre fermée (2) pour le dépôt de substances liquides en vue de la formation du système de couches, dans lequel celle-ci présente un logement tournant (3) pour des substrats et un dispositif de collecte (4) entourant le logement tournant (3) et disposé dans la chambre (2) pour le dépôt de substances liquides afin de collecter des substances liquides centrifugées du substrat,
dans lequel le dispositif de collecte présente plusieurs points de prélèvement (5), au moyen desquels des substances liquides collectées peuvent être prélevées individuellement ou en mélange de façon sélective et être de nouveau introduites soit directement soit après une courte préparation dans le processus pour la fabrication de substrats structurés, dans lequel le dispositif de collecte (4) entoure dans la chambre (2) le logement (3) sous forme annulaire et présente plusieurs zones de collecte (9) séparées l'une de l'autre par des éléments de séparation (7) et destinées à collecter des substances liquides centrifugées, et
dans lequel le dispositif de collecte (4) présente sur le côté associé au logement (3) plusieurs éléments de séparation (7) en forme de paroi, qui forment plusieurs rigoles annulaires (9) comme zones de collecte (9), qui sont munies d'un ou de plusieurs point (s) de prélèvement (5),
dans lequel le dispositif de collecte (4) présente sur le côté associé au logement (3) plusieurs éléments de séparation (7) en forme de paroi, qui forment plusieurs rigoles annulaires (9) de section transversale en forme de coin comme zones de collecte (9),
dans lequel le dispositif de collecte avec les multiples rigoles annulaires et de section transversale en forme de coin (9) qui forment les zones de collecte (9), est réalisée sous forme déplaçable,
dans lequel plusieurs rigoles annulaires (9) sont formées exclusivement par des éléments de séparation en forme de paroi (7) et une paroi commune (8) du dispositif de collecte (4),
dans lequel la chambre (2) pour le dépôt de substances liquides est formée de façon étanche au gaz par une enceinte (6) et
dans lequel la chambre (2) pour le dépôt de substances liquides est remplie de gaz inerte.

2. Ensemble pour la fabrication de substrats structurés selon la revendication 1, **caractérisé en ce que** le dispositif de collecte (4) est réalisé sous forme déplaçable par rapport au logement (3), de telle manière que différentes zones de collecte (9) entrent en action en fonction du déplacement pour la collecte de substances liquides centrifugées.

3. Ensemble pour la fabrication de substrats structurés selon la revendication 1 ou 2, **caractérisé en ce que** la paroi commune (8) présente la forme d'un cylindre creux ou d'un cône creux.

4. Ensemble pour la fabrication de substrats structurés selon l'une quelconque des revendications 1 à 3, **caractérisé en ce que** les éléments de séparation en forme de paroi (7) sont essentiellement parallèles l'un à l'autre.

5. Ensemble pour la fabrication de substrats structurés selon l'une quelconque des revendications précédentes, **caractérisé en ce que** la chambre (2) pour le dépôt de substances liquides est entourée de façon étanche au gaz par une enceinte (6) en acier V4A ou en verre.

6. Ensemble pour la fabrication de substrats structurés selon l'une quelconque des revendications précédentes, **caractérisé en ce que** la chambre (2) pour le dépôt de substances liquides est remplie de gaz inerte déshumidifié.

7. Ensemble pour la fabrication de substrats structurés selon l'une quelconque des revendications précédentes 1 à 6, **caractérisé en ce qu'**il est prévu un dispositif de prélèvement (10) séparé de la chambre (2) pour le dépôt de substances liquides, qui transporte les substances liquides accumulées dans le dispositif de collecte (4) via les points de prélèvement (5) de façon sélective dans des récipients de stockage séparés (11), dans lequel les récipients de stockage (11) conviennent pour le stockage en particulier de substances liquides dégazées et/ou déshumidifiées, en particulier de solutions de photopolymères.

8. Ensemble pour la fabrication de substrats structurés selon la revendication 7, **caractérisé en ce que** le récipient de stockage (11) est fabriqué en acier V4A ou en verre et est raccordé au dispositif de collecte (4) et au dispositif de prélèvement (10) par une conduite de transport (12) étanche au gaz.

9. Ensemble pour la fabrication de substrats structurés selon l'une quelconque des revendications 1 à 8, **caractérisé en ce qu'**il est prévu au moins une arrivée (13) pour les substances liquides à la chambre (2) pour le dépôt de substances liquides et ladite au moins une arrivée (13) et/ou le dispositif de prélèvement (10) est munie/muni de récipients de stockage (11) avec au moins un dispositif de dégazage (14) et en particulier avec au moins un dispositif de déshumidification (15).

10. Ensemble pour la fabrication de substrats structurés selon la revendication 9, **caractérisé en ce que** le dispositif de dégazage (14) présente une conduite d'arrivée (16) pour du gaz inerte, en particulier pour de l'azote moléculaire et/ou un gaz noble en particulier l'hélium, le néon ou l'argon et un tamis disposé dans la région du fond du récipient de stockage (11), à travers les ouvertures duquel du gaz inerte, en particulier sous forme de gaz séché, s'écoule pour le dégazage et en particulier pour la déshumidification des substances liquides, en particulier de solutions de photopolymères.

11. Ensemble pour la fabrication de substrats structurés selon la revendication 10, **caractérisé en ce que** la conduite d'arrivée (12) est munie d'un tamis moléculaire (17) ou de filtres au dioxyde de manganèse ou à la limonite des prairies pour la déshumidification du gaz inerte en circulation.

12. Ensemble pour la fabrication de substrats structurés selon l'une quelconque des revendications précédentes, **caractérisé en ce qu'**il est prévu un filtre pour le filtrage des particules (18) après le dispositif de collecte (4).

13. Ensemble pour la fabrication de substrats structurés selon l'une quelconque des revendications précédentes 7 à 12, **caractérisé en ce qu'**il est prévu un dispositif de distillation sous vide (20), qui sépare les substances liquides dans les divers récipients de stockage (11) par distillation en leurs composants en particulier en eau, solvants et substances liquides, en particulier en solutions de photopolymères, et transfère les composants séparés dans des réservoirs de stockage étanches au gaz (19), dans lequel ceux-ci sont dotés en particulier d'une atmosphère composée de gaz inerte.
